# EUROPÄISCHE PATENTSCHRIFT

(11) **EP 0 852 040 B1**
(45) Veröffentlichungstag und Bekanntmachung des Hinweises auf die Patenterteilung: **21.07.1999**
(21) Anmeldenummer: 96938937.8
(22) Anmeldetag: 17.09.1996
(51) Int. Cl.: G06K 19/077

(54) **IC-KARTENMODUL ZUR HERSTELLUNG EINER IC-KARTE SOWIE VERFAHREN ZUR HERSTELLUNG EINER IC-KARTE**
IC BOARD MODULE FOR PRODUCING AN IC BOARD AND PROCESS FOR PRODUCING AN IC BOARD
MODULE CARTE DE CI POUR LA FABRICATION D'UNE CARTE DE CI ET PROCEDE DE FABRICATION D'UNE CARTE DE CI

(30) Priorität: 18.09.1995 DE 19534480
(43) Veröffentlichungstag der Anmeldung: 08.07.1998
(73) Patentinhaber: Finn, David, 87629 Füssen-Weissensee (DE); Rietzler, Manfred, 87616 Marktoberdorf (DE)
(72) Erfinder: Finn, David, 87629 Füssen-Weissensee (DE); Rietzler, Manfred, 87616 Marktoberdorf (DE)
(74) Vertreter: Böck, Bernhard, Dipl.-Ing.
(86) Internationale Anmeldenummer: DE9601752
(87) Internationale Veröffentlichungsnummer: WO9711437

(56) Entgegenhaltungen:
- EP-A- 0 646 895
- DE-A- 4 105 869
- DE-A- 4 311 493

## Beschreibung

Die vorliegende Erfindung betrifft ein IC-Kartenmodul zur Herstellung einer IC-Karte nach dem Oberbegriff der Ansprüche 1 und 2, die Verwendung eines derartigen IC-Kartenmoduls in einer IC-Karte sowie ein Verfahren zur Herstellung einer IC-Karte unter Verwendung eines derartigen IC-Kartenmoduls nach dem Oberbegriff des Anspruchs 9.

IC-Karten enthalten einen in einem Kartenkörper installierten Chip als Datenträger und ermöglichen je nach Ausführung einen berührungslosen oder berührungsbehafteten Zugriff auf den Datenträger. Für einen berührungsbehafteten Kontakt sind auf dem Kartenträger Kontaktfelder vorgesehen, die eine Verbindung mit entsprechend angeordneten Kontaktstellen in einer Gegeneinrichtung ermöglichen. Ein berührungsloser Zugriff auf die Daten des Chips wird möglich, wenn dieser mit einer Spule zu einer Transpondereinheit ergänzt ist.

Aus der DE 43 11 493 A1 ist ein in einen Kartenkörper einsetzbares IC-Kartenmodul bekannt, das die Herstellung einer IC-Karte ermöglich, die sowohl einen berührungsbehafteten Zugriff auf den Chip über Kontaktfelder als auch einen berührungslosen Zugriff auf den Chip mittels einer den Chip zu einer Transpondereinheit ergänzenden Spule ermöglicht. Dabei sind der Chip und die Spule über einen Modulträger miteinander verbunden, der sowohl eine elektrisch leitfähige Verbindung zwischen dem Chip und der Spule als auch eine elektrisch leitfähige Verbindung zwischen dem Chip und einer Kontaktfelder aufweisenden Außenkontaktfläche des Modulträgers ermöglicht.

Die Verwendung des aus der DE 43 11 493 A1 bekannten IC-Kartenmoduls zur Herstellung einer IC-Karte setzt die Bereitstellung eines mit einer entsprechenden Ausnehmung versehenen Kartenkörpers voraus, in den sich das bekannte IC-Kartenmodul einsetzen läßt. Die verliersichere Verbindung des IC-Kartenmoduls mit dem Kartenkörper muß in einem von der Herstellung des Kartenkörpers unabhängigen, separaten Fertigungsschritt durchgeführt werden. Hieraus ergibt sich insgesamt ein erhöhter Aufwand bei der IC-Kartenherstellung; insbesondere deswegen, weil die Verbindung des IC-Kartenmoduls mit dem Kartenkörper, die beispielsweise mittels Klebung erfolgt, so durchgeführt werden muß, daß im Ergebnis die Außenkontaktfläche des IC-Kartenmoduls bündig zur Oberfläche des Kartenkörpers ist, um einen betriebssicheren Gebrauch einer derartigen IC-Karte, etwa in einem Geldautomaten, sicherzustellen.

Aus der DE-A-41 05 869 ist ein IC-Kartenmodul zur Herstellung einer IC-Karte bekannt, das mit zwei Spulen und einem Chip zur Ausbildung einer Transpondereinheit versehen ist, wobei der Chip und die Spulen über einen Modulträger miteinander verbunden sind, der sowohl Spulenkontakt-Leiterbahnen zur elektrisch leitfähigen Verbindung zwischen dem Chip und der Spule als auch Außenkontakt-Leiterbahnen zur elektrisch leitfähigen Verbindung zwischen einer Außenkontaktfläche des Modulträgers und dem Chip aufweist. Bei dem bekannten IC-Kartenmodul ist eine Rückhalteeinrichtung zur Sicherung des IC-Kartenmoduls in einem Kartenkörper durch den Modul träger des IC-Kartenmoduls gebildet.

Der vorliegenden Erfindung liegt die Aufgabe zugrunde, ein IC-Kartenmodul zur Herstellung einer IC-Karte vorzuschlagen, das eine vom Modulträger unabhängige Ausbildung einer Rückhalteeinrichtung aufweist. Des weiteren ist es Aufgabe der vorliegenden Erfindung, eine IC-Karte vorzuschlagen, die mit einem derartigen IC-Kartenmodul versehen ist, sowie ein Verfahren zur Herstellung zur Herstellung einer derartigen IC-Karte vorzuschlagen.

Zur Lösung wird ein IC-Kartenmodul mit den Merkmalen der Ansprüche 1 oder 2 sowie eine IC-Karte mit den Merkmalen des Anspruchs 8 und ein Verfahren mit den Merkmalen des Anspruchs 13 oder 14 vorgeschlagen.

Bei einem ersten erfindungsgemäßen Kartenmodul ist zur Ausbildung der Rückhalteeinrichtung die Spule derart gegenüber dem Modulträger angeordnet ist, daß sie sich zumindest teilweise außerhalb der Außenkontaktfläche erstreckt. Hierdurch entfällt die Notwendigkeit, zur Ausbildung der Rückhalteeinrichtung eine entsprechende Ausgestaltung des Modulträgers vorzusehen. Vielmehr ist die ohnehin mit dem Modulträger verbundene Spule so angeordnet, daß sie als Rückhalteeinrichtung wirkt.

Bei einem zweiten erfindungsgemäßen IC-Kartenmodul ist die Rückhalteeinrichtung aus Spulenkontakt-Leiterbahnen einer auf dem Modulträger angeordneten Leiterbahnstruktur gebildet, die zur Herstellung der elektrisch leitfähigen Verbindung zwischen dem Chip und der Spule dienen. Hierbei werden nämlich die ohnehin zur Herstellung der elektrischen Verbindung zwischen der Spule und dem Chip notwendigen Leiterbahnen gleichzeitig zur Ausbildung der Auslegereinrichtung genutzt, so daß die separate Ausbildung einer Einrichtung, die lediglich eine Rückhaltefunktion erfüllt, überflüssig wird. Dabei sind die Spulenkontakt-Leiterbahnen gegenüberliegend von Außenkontakt-Leiterbahnen zur Herstellung der elektrisch leitfähigen Verbindung zwischen Kontaktfeldern der Außenkontaktfläche und dem Chip angeordnet, so daß von vornherein der für die Verwendung der Spulenkontakt-Leiterbahnen als Rückhalteeinrichtung notwendige Rücksprung gegeben ist, ohne daß diese verformt werden müßten.

Eine möglichst flache Bauhöhe des IC-Kartenmoduls wird auch dadurch gefördert, daß die Kontaktierung von Spulendrahtenden der Spule auf Leiterbahnenden der Spulenkontakt-Leiterbahnen auf einer Kontaktfläche vorgesehen ist, die einer Außenkontaktflächenebene, in der die Außenkontaktfläche angeordnet ist, zugewandt ist.

Eine Verbindung von Chip-Anschlußflächen mit den Spulenkontakt-Leiterbahnen und den Außenkontakt-Leiterbahnen mittels Drahtbondverbindungen hat den Vorteil, daß die Verbindungen zwischen den Leiterbahnen und den Chip-Anschlußflächen beliebig orientiert werden können.

Bei Verwendung von Kontaktmetallisierungen als Verbindung zwischen den Spulenkontakt-Leiterbahnen und den Chip-Anschlußflächen sowie den Außenkontakt-Leiterbahnen und den Chip-Anschlußflächen läßt sich ein im wesentlichen unmittelbarer Kontakt mit entsprechend geringer Bauhöhe des IC-Kartenmoduls erzielen.

Eine besonders kompakte Ausbildung des Modulträgers wird auch möglich, wenn die Außenkontakt-Leiterbahnen in die Kontaktfelder übergehend ausgebildet sind; etwa dann, wenn die Kontaktfelder durch Endbereiche der Außenkontakt-Leiterbahnen gebildet sind.

Bei einer IC-Karte, die unter Verwendung des vorstehend in verschiedenen Ausführungsformen beschriebenen IC-Kartenmoduls hergestellt ist, ist das IC-Kartenmodul derart in einem Kartenkörper der IC-Karte angeordnet, daß die mit mindestens einem Kontaktfeld versehene Außenkontaktfläche im wesentlichen bündig mit der Oberfläche der IC-Karte angeordnet ist und die Rückhalteeinrichtung des IC-Kartenmoduls einen an die Kontaktfläche angrenzenden Rückhaltebereich des Kartenkörpers hintergreift.

In einer Ausführungsform der IC-Karte ist der Rückhaltebereich Teil eines monolithisch ausgebildeten Kartenkörpers. In einer anderen Ausführungsform ist der Rückhaltebereich Teil einer Trägerschicht eines zumindest aus zwei Schichten gebildeten Kartenkörpers.

Wenn die Rückahlteeinrichtung zwischen der Trägerschicht und einer Gegenschicht aufgenommen wird, wobei die Rückhalteeinrichtung zumindest teilweise in der Trägerschicht eingebettet ist, läßt sich der Kartenkörper im Laminierverfahren herstellen, wobei in einem ersten Verfahrensschritt eine aus der Trägerschicht und dem IC-Kartenmodul bestehende Einheit herstellbar ist, die bei der weiteren Herstellung der IC-Karte analog einer Laminatschicht einfach handhabbar ist. Alternativ ist auch eine Verbindung der Rückhalteeinrichtung mit der Trägerschicht über einen Kleberauftrag möglich.

Bei einer ersten Variante des Verfahrens zur Herstellung einer IC-Karte unter Verwendung des in verschiedenen Ausführungsformen beschriebenen IC-Kartenmoduls wird das IC-Kartenmodul mit der Außenkontaktfläche bis zur Anlage der Rückhalteeinrichtung an einer Verbindungsoberfläche der Trägerschicht in eine Aufnahmeöffnung der Trägerschicht eingesetzt und es erfolgt eine Verbindung der Rückhalteeinrichtung mit der Trägerschicht unter Einwirkung von Druck und Temperatur und/oder Ultraschall. Anschließend wird die Gegenschicht auf die Verbindungsoberfläche der Trägerschicht aufgebracht.

Bei einer anderen Variante des Verfahrens zur Herstellung einer IC-Karte unter Verwendung des in verschiedenen Ausführungsformen vorstehend beschriebenen IC-Kartenmoduls wird auf der Rückhalteeinrichtung eine Trägerschicht mit einer Öffnung im Bereich der Außenkontaktfläche des IC-Kartenmoduls ausgebildet, derart, daß eine Verbindung zwischen der Rückhalteeinrichtung und der Trägerschicht erfolgt. Anschließend wird die Gegenschicht auf die Trägerschicht und eine der Außenkontaktfläche gegenüberliegende Rückseite des IC-Kartenmoduls aufgebracht. Diese Verfahrensvariante ermöglicht beispielsweise die Herstellung der Trägerschicht im Spritzverfahren.

Eine weitere Verfahrensvariante zur Herstellung einer IC-Karte unter Verwendung des in verschiedenen Ausführungsformen vorstehend beschriebenen IC-Kartenmoduls besteht darin, auf der Rückhalteeinrichtung den Kartenkörper als Ganzes mit einer Ausnehmung im Bereich der Außenkontaktfläche auszubilden. Auch die Ausbildung eines monolithischen Kartenkörpers kann beispielsweise im Spritzverfahren geschehen.

Nachfolgend werden verschiedene Ausführungsformen des IC-Kartenmoduls sowie eine unter Verwendung einer Ausführungsform des IC-Kartenmoduls hergestellte IC-Karte anhand der Zeichnungen näher beschrieben. Es zeigen:
- **Fig. 1**: ein IC-Kartenmodul in einer ersten Ausführungsform;
- **Fig. 2**: das in **Fig. 1** dargestellte IC-Kartenmodul in Draufsicht;
- **Fig. 3**: ein IC-Kartenmodul in einer weiteren Ausführungsform in Draufsicht;
- **Fig. 4**: das in **Fig. 3** dargestellte IC-Kartenmodul in einer Schnittdarstellung gemäß Schnittlinienverlauf IV - IV in **Fig. 3**;
- **Fig. 5**: eine Schnittdarstellung des in **Fig. 3** dargestellten IC-Kartenmoduls längs dem Schnittlinienverlauf V - V in **Fig. 3**;
- **Fig. 6**: ein IC-Kartenmodul gemäß einer weiteren Ausführungsform in Daraufsicht;
- **Fig. 7**: das in **Fig. 6** dargestellte IC-Kartenmodul in einer Schnittdarstellung gemäß dem Schnittlinienverlauf VII - VII in **Fig. 6**;
- **Fig. 8**: das in **Fig. 6** dargestellte IC-Kartenmodul in einer Schnittdarstellung gemäß dem Schnittlinienverlauf VIII - VIII in **Fig. 6**;
- **Fig. 9**: ein IC-Kartenmodul in einer weiteren Ausführungsform;
- **Fig. 10**: ein IC-Kartenmodul in einer weiteren Ausführungsform;
- **Fig. 11**: eine IC-Karte mit einem IC-Kartenmodul gemäß der in **Fig. 1** dargestellten Ausführungsform.

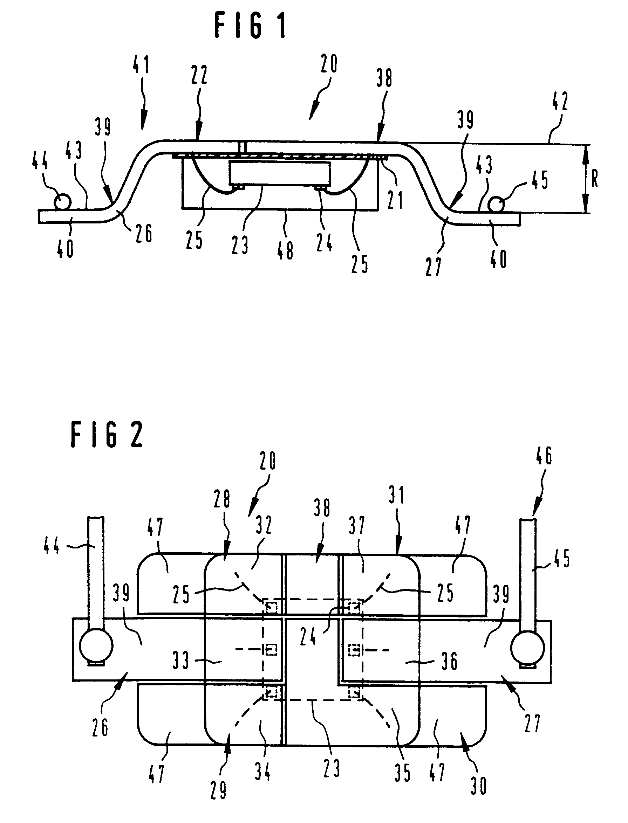

Die **Fig. 1** und **2** zeigen ein IC-Kartenmodul 20 mit einem Modulträger 21, der auf seiner Oberseite mit einer Leiterbahnstruktur 22 versehen ist und auf dessen Unterseite ein Chip 23 angeordnet ist.

Wie aus **Fig. 2** deutlich wird, weist der hier beispielhaft verwendete Chip 23 insgesamt sechs Chipanschlußflächen 24 auf, die über Drahtbondverbindungen 25 mit Spulenkontakt-Leiterbahnen 26, 27 und Außenkontaktleiterbahnen 28, 29, 30, 31 verbunden sind.

In dem vorliegenden Ausführungsbeispiel erstrecken sich sowohl die Spulenkontakt-Leiterbahnen 26, 27 als auch die Außenkontakt-Leiterbahnen 28 bis 31 zu einem Teil auf der Oberseite des Modulträgers 21, wo sie mit ihren Endbereichen Kontaktfelder 32 bis 37 bilden, die über die Drahtbondverbindungen 25 mit jeweils einer Chip-Anschlußfläche 24 verbunden sind.

Wie aus **Fig. 1** deutlich wird, weisen die Spulenkontakt-Leiterbahnen 26, 27 jeweils einen über eine durch die Kontaktfelder 32 bis 37 gebildete Außenkontaktfläche 38 hinausgehenden Überstand 39 auf, der in einem Endbereich 40 durch einen Rücksprung R von der Außenkontaktfläche 38 beabstandet ist. Im Übergang von der Außenkontaktfläche 38 zum Endbereich 40 ist der Überstand 39 der Spulenkontakt-Leiterbahnen S-Schlagförmig ausgebildet.

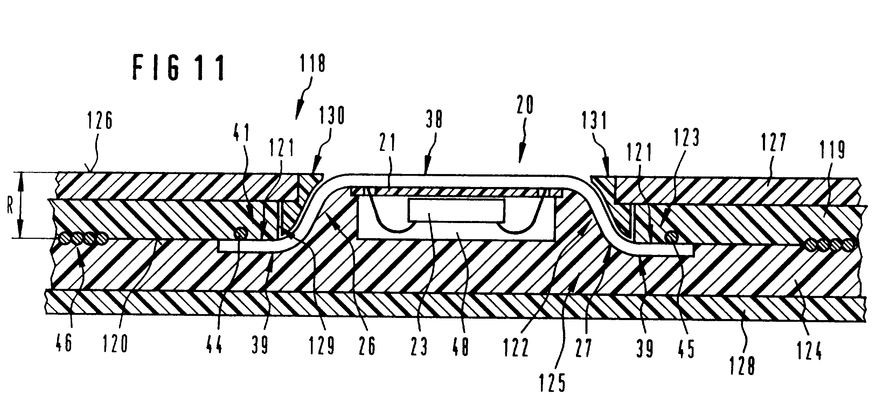

Die derart ausgebildeten Überstände 39 der Spulenkontakt-Leiterbahnen 26, 27 wirken zusammen als eine Rückhalteeinrichtung 41, deren Funktion nachfolgend anhand der **Fig. 11** noch ausführlich erläutert wird.

Wie aus den **Fig. 1** und **2** weiterhin zu ersehen ist, sind die Endbereiche 40 der Spulenkontakt-Leiterbahnen 26, 27 auf einer einer Außenkontaktflächenebene 42 zugewandten Kontaktfläche 43 elektrisch leitend - beispielsweise mittels einer Thermokompressionsverbindung - mit Spulendrahtenden 44, 45 einer hier nur unvollständig dargestellten Spule 46 verbunden. Da sich die Spule im vorliegenden Fall außerhalb der Außenkontaktfläche 38 erstreckt, bildet auch sie einen Teil der Rückhalteeinrichtung 41, was ebenfalls unter Bezugnahme auf die **Fig. 11** nachfolgend noch eingehender erläutert wird.

Bei dem in den **Fig. 1** und **2** dargestellten Ausführungsbeispiel des IC-Kartenmoduls 20 erstrecken sich ebenfalls die Außenkontakt-Leiterbahnen 28 bis 31 ausgehend von den Kontaktfeldern 32, 34, 35 und 37 mit Überständen 47 über die Außenkontaktfläche 38 hinaus und sind in gleicher Weise wie die Überstände 39 der Spulenkontakt-Leiterbahnen 26, 27 S-Schlagförmig geformt zur Ausbildung des Rücksprungs R. Damit tragen bei dem in den **Fig. 1** und **2** dargestellten IC-Kartenmodul 20 auch die Überstände 47 der Außenkontakt-Leiterbahn 28 bis 31 zur Ausbildung der Rückhalteeinrichtung 41 bei.

Bei dem in den **Fig. 1** und **2** dargestellten IC-Kartenmodul 20 weisen auch die Spulenkontakt-Leiterbahnen 26, 27, die über die Drahtbondverbindungen 25 eine elektrische Verbindung der Spule 46 mit den entsprechenden Chip-Anschlußflächen ermöglichen, Kontaktfelder 33, 36 auf, so daß ein Zugriff auf die entsprechenden Chip-Anschlußflächen 24 sowohl berührungsbehaftet über die Kontaktfelder 33 und 36 als auch berührungslos über die Spule 46 erfolgen kann. Die Außenkontakt-Leiterbahnen 28 bis 31 ermöglichen über die Kontaktfelder 32, 34, 35 und 37 lediglich einen berührungsbehafteten Zugriff auf die entsprechenden Chip-Anschlußflächen 24.

**Fig. 1** zeigt, daß der auf der Unterseite des Modulträgers 21 mit seinen Chip-Anschlußflächen 24 nach unten weisend angeordnete Chip 23 mit einem Verguß 48 versehen ist, der sowohl den Chip 23 als auch die von den Chip-Anschlußflächen 24 zu den Spulenkontakt-Leiterbahnen 26, 27 und den Außenkontakt-Leiterbahnen 28, 31 führenden Drahtbondverbindungen 25 abschirmt.

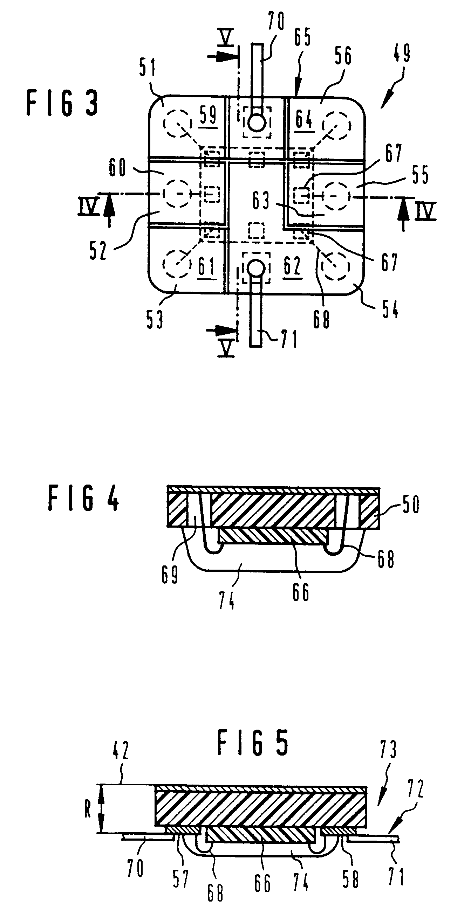

In den **Fig. 3, 4** und **5** ist ein IC-Kartenmodul 49 dargestellt, bei dem auf der Oberseite eines Modulträgers 50 (**Fig. 4, 5**) Außenkontakt-Leiterbahnen 51 bis 56 und auf der Unterseite Spulenkontakt-Leiterbahnen 57 und 58 (**Fig. 5**) angeordnet sind.

Die Außenkontakt-Leiterbahnen 51 bis 56 bilden mit ihren Oberseiten insgesamt sechs Kontaktfelder 59 bis 64 und erstrecken sich bei dem hier dargestellten Ausführungsbeispiel nicht über eine Außenkontaktfläche 65 des IC-Kartenmoduls 49 hinaus.

Wie aus einer Zusammenschau der **Fig. 3** und **4** deutlich wird, weist ein auf der Unterseite des Modulträgers 50 angeordneter Chip 66 insgesamt acht Anschlußflächen 67 auf, die jeweils über Drahtbondverbindungen 68 mit den Außenkontaktleiterbahnen 51 bis 56 verbunden sind. Hierzu sind die Drahtbondverbindungen 68 durch Bondöffnungen 69 (**Fig. 4**) im Modulträger 50 hindurchgeführt. Ebenso ist es möglich, anstelle der Bondöffnungen 69 hier nicht näher dargestellte Durchkontaktierungen zum Anschluß der Drahtbondverbindungen 68 an die Außenkontakt-Leiterbahnen 51 bis 56 zu verwenden.

Wie aus **Fig. 5** deutlich wird, erfolgt der Anschluß der Chip-Anschlußflächen 67 an die Spulenkontakt-Leiterbahnen 57, 58 ebenfalls über jeweils eine Drahtbondverbindung 68. An die Spulenkontakt-Leiterbahnen 57, 58 sind beispielsweise mittels einer Thermokompressionsverbindung Spulendrahtenden 70, 71 einer hier nur unvollständig dargestellten Spule 72 angeschlossen. Die Spulendrahtenden 70, 71 erstrecken sich nach außerhalb der Außenkontaktfläche 65 und bilden somit zusammen mit den ebenfalls außerhalb der Außenkontaktfläche 65 angeordneten Bereichen der Spule 72 eine Rückhalteeinrichtung 73, die infolge der Anordnung von Außenkontakt-Leiterbahnen 51 bis 56 einerseits und Spulenkontakt-Leiterbahnen 57 und 58 andererseits auf gegenüberliegenden Seiten des Modulträgers 50 um einen Rücksprung R von der Außenkontaktflächenebene 42 beabstandet sind. Wie bei dem anhand der **Fig. 1** und **2** erläuterten IC-Kartenmoduls 20 kann auch bei dem IC-Kartenmodul 49 eine Abschirmung des Chips 66 sowie der Drahtbondverbindungen 68 über einen Verguß 74 erfolgen.

Abweichend von dem eingangs erläuterten IC-Kartenmodul 20 ist ein Zugriff auf die an die Spulenkontakt-Leiterbahnen 57, 58 angeschlossenen Chip-Anschlußflächen 67 nur berührungslos über die Spule 72 möglich. Übereinstimmend mit dem IC-Kartenmodul 20 ist auch bei dem IC-Kartenmodul 49 ein Zugriff auf die mit den Außenkontakt-Leiterbahnen 51 bis 56 verbundenen Chip-Anschlußflächen 67 lediglich berührungsbehaftet über die Kontaktfelder 59 bis 64 möglich.

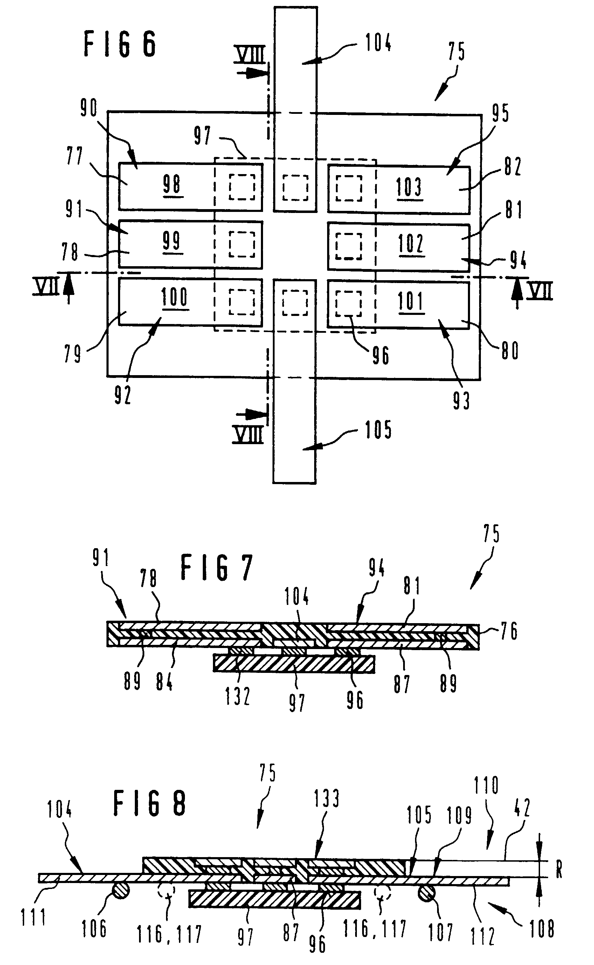

In den **Fig. 6, 7** und **8** ist ein IC-Kartenmodul 75 mit einem Modulträger 76 (**Fig. 7**) dargestellt, der auf seiner Oberseite und seiner Unterseite Außenkontakt-Leiterbahnen 77 bis 88 aufweist, die jeweils paarweise über eine Durchkontaktierung 89 (**Fig. 7**) miteinander verbunden Außenkontaktleiter 90 bis 95 zum Anschluß an Chip-Anschlußflächen 96 eines Chips 97 bilden. Der Chip 97 ist im vorliegenden Fall mit seinen Chip-Anschlußflächen 96 über Kontaktmetallisierungen 132 direkt mit den Außenkontaktleitern 90 bis 95 verbunden. Die Verbindung des Chips 97 mit den Außenkontaktleitern 90 bis 95 kann daher mit der an sich bekannten Flip-Chip-Technologie erfolgen.

Gemäß dem in **Fig. 7** dargestellten Ausführungsbeispiel bilden die auf der Oberseite des Modulträgers 76 angeordneten Außenkontakt-Leiterbahnen 77 bis 82 Kontaktfelder 98 bis 103, die einen berührungsbehafteten Zugriff auf die mit den Außenkontaktleitern 90 bis 95 verbundenen Chip-Anschlußflächen 96 ermöglichen.

Wie darüber hinaus aus den **Fig. 6** bis **7** zu ersehen ist, sind auf der Unterseite des Modulträgers 76 neben den Außenkontakt-Leiterbahnen 83 bis 88 zwei Spulenkontakt-Leiterbahnen 104, 105 angeordnet, die, wie insbesondere aus **Fig. 8** zu ersehen ist, eine elektrische Verbindung zwischen Spulendrahtenden 106, 107 einer nur unvollständig dargestellten Spule 108 und zugeordneten Chip-Anschlußflächen 96 des Chips 97 ermöglichen. Die Spulenkontakt-Leiterbahnen 104, 105 weisen einen über eine Außenkontaktfläche 133 seitlich hervorragenden Überstand 109 auf, der mit einem Rücksprung R gegenüber der Außenkontaktflächenebene 42 angeordnet ist und somit als eine Rückhalteeinrichtung 110 wirkt.

Aus **Fig. 8** wird ersichtlich, daß bei dem IC-Kartenmodul 75 Kontaktflächen 111, 112 zur Verbindung mit den Spulendrahtenden 106 und 107 von der Außenkontaktflächenebene 42 abgewandt sind, was zur Folge hat, daß die Spulendrahtenden 106, 107 im wesentlichen in der Ebene des Chips 97 angeordnet sind und trotz der Verbindung der Spulendrahtenden 106, 107 mit den Spulenkontakt-Leiterbahnen 104, 105 ein ausreichender Rücksprung R verbleibt, so daß diese im Bereich ihrer Überstände 109 als Rückhalteeinrichtung 110 wirken können. Darüber hinaus hat die in **Fig. 8** dargestellte Ausführungsform den Vorteil, daß die Ausbildung einer Rückhalteeinrichtung 110 bei insgesamt besonders geringer Bauhöhe des IC-Kartenmoduls 75 möglich ist.

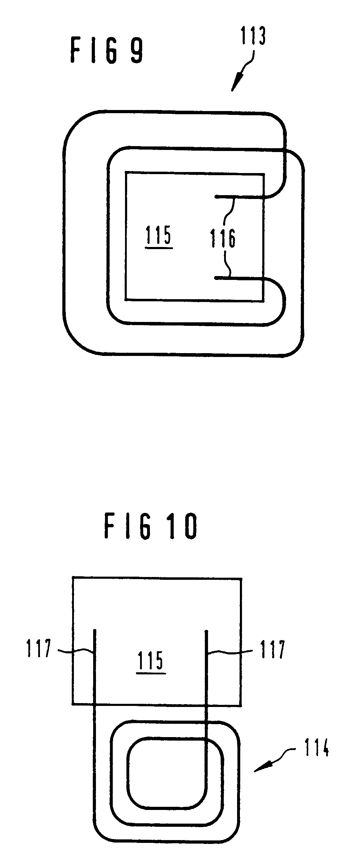

In den **Fig. 9** und **10** sind zwei beispielhafte Konfigurationen von Spulen 113 (**Fig. 9**) und 114 (**Fig. 10**) dargestellt, die die Ausbildung einer Rückhalteeinrichtung bei einem IC-Kartenmodul 115 ermöglichen, das bis auf fehlende Überstände 109 mit dem IC-Kartenmodul 75 übereinstimmt. Die Lage von Spulendrahtenden 116 bzw. 117 sind für diesen Fall in **Fig. 8** mit gestricheltem Linienverlauf dargestellt.

**Fig. 11** zeigt eine IC-Karte 118, die unter Verwendung des anhand von **Fig. 1** beispielhaft erläuterten IC-Kartenmoduls 20 hergestellt worden ist. Nachfolgend soll unter Bezugnahme auf die **Fig. 11** ein mögliches Verfahren zur Herstellung der IC-Karte 118 näher erläutert werden.

Ausgehend von dem IC-Kartenmodul 20, mit dessen Spulenkontakt-Leiterbahnen 26, 27 die Spulendrahtenden 44, 45 der Spule 46 verbunden sind, erfolgt zunächst eine Verbindung des IC-Kartenmoduls 20 mit einer Trägerschicht 119. Die Verbindung des IC-Kartenmoduls 20 mit der Trägerschicht 119 erfolgt zum einen über eine formschlüssige Verbindung der Spule 46 im Bereich einer Verbindungsoberfläche 120 der Trägerschicht 119; zum anderen auch über die Spulenkontakt-Leiterbahnen 26, 27 in deren Kontaktbereich 121 zur Verbindungsoberfläche 120. Abweichend von der Darstellung in **Fig. 11** kann die Eindringtiefe der Spule 46 bzw. die Eindringtiefe der Kontaktbereiche 121 der Spulenkontakt-Leiterbahnen 26, 27 variieren zwischen einem nur teilweisen Kontakt und einer nahezu vollständigen Einbettung. Die Verbindung kann beispielsweise mittels Druck und Temperatur; jedoch auch unter Einwirkung von Ultraschall durchgeführt werden. Abweichend von der Darstellung in **Fig. 11** ist es auch möglich, die hier von den Spulenkontakt-Leiterbahnen 26, 27 und der Spule 46 gebildete Rückhalteeinrichtung 41 nicht unmittelbar, sondern über einen hier nicht näher dargestellten Kleberauftrag auf der Trägerschicht anzuordnen, wobei dann die Verbindungsoberfläche zumindest teilweise durch den Kleberauftrag gebildet ist.

Zur Herstellung der in **Fig. 11** dargestellten Verbindung zwischen dem IC-Kartenmodul 20 und der Trägerschicht 119 kann das IC-Kartenmodul 20 mit seiner Außenkontaktfläche 38 soweit in eine Einsetzöffnung 122 der Trägerschicht 119 eingebracht werden, bis die Spule 46 bzw. die Spulenkontaktleiterbahn 26, 27 an der Verbindungsoberfläche 120 anliegen und die eigentliche Verbindung durchgeführt werden kann.

Das IC-Kartenmodul 20 bildet zusammen mit der Trägerschicht 119 ein Karteninlet 123, das als Einheit in konventioneller Laminattechnik zu der in **Fig. 11** dargestellten IC-Karte 118 weiterverarbeitet werden kann. Dabei ist die Reihenfolge der nachfolgend beispielhaft beschriebenen Laminierungsvorgänge variierbar. Vorteilhaft ist es, wenn ausgehend von dem Karteninlet 123 anschließend eine Gegenschicht 124 auf die Verbindungsoberfläche 120 der Trägerschicht 119 laminiert wird, so daß bis auf die in die Einsetzöffnung 122 hineinragende Außenkontaktfläche 38 des IC-Kartenmoduls 20 ein Kartenkörper 125 mit in sich geschlossener, ebener Oberfläche gebildet wird. Je nach Ausbildung der Trägerschicht 119 und der Gegenschicht 124 kann die IC-Karte 118 abweichend von der Darstellung in **Fig. 11** aus lediglich zwei Schichten aufgebaut sein. In diesem Fall weist die Trägerschicht 119 eine derartige Dicke auf, daß das IC-Kartenmodul 20 mit seiner Außenkontaktfläche 38 bündig zu einer Außenfläche 126 der Trägerschicht 119 ist.

Bei der in **Fig. 11** dargestellten IC-Karte 118 sind auf die Trägerschicht 119 und die Gegenschicht 124 noch Deckschichten 127, 128 laminiert, die als sogenannte Personalisierungsschichten, also beispielsweise mit einem Bild des Karteninhabers und etwaigen bibliographischen Daten versehen, ausgebildet sein können. Eine weitere Möglichkeit besteht in der Verwendung der Deckschichten als Werbeträger oder dergleichen.

Zur Anpassung von Schichträndern 129 und 130 der Trägerschicht 119 und der Deckschicht 127 an den S-Schlagförmig ausgebildeten Bereich der Spulenkontakt-Leiterbahnen 26, 27 kann eine Verfüllung 131 aus einem Klebstoff oder einem Vergußmaterial im Bereich der Schichtränder 129, 130 vorgesehen werden. Möglich ist auch das Erreichen einer derartigen Anpassung unter thermoplastischer Verformung der Schichtränder 129, 130, beispielsweise während der Herstellung der Verbindung zwischen dem IC-Kartenmodul 20 und der Trägerschicht 119 bzw. der Deckschicht 127.

Aus der Darstellung gemäß **Fig. 11** wird deutlich, daß die Überstände 39 der Spulenkontakt-Leiterbahnen 26, 27 und auch die damit verbundene Spule 46 als Rückhalteeinrichtung 41 oder Verbindungseinrichtung wirken, die das IC-Kartenmodul 20 in der IC-Karte 118 sichert. Diese Funktion wird unabhängig von der Art und Weise der Herstellung des IC-Kartenmoduls 20 erreicht. So kann zur Ausbildung des IC-Kartenmoduls 20 auch zunächst die Spule 46 auf der Verbindungsoberfläche 120 der Trägerschicht 119 appliziert werden und anschließend eine Verbindung zwischen den Spulendrahtenden 44, 45 und den Spulenkontakt-Leiterbahnen 26, 27 zur Ausbildung des IC-Kartenmoduls 20 erfolgen. Insbesondere in diesem Fall bietet sich eine Ausbildung der Spule 46 als sogenannte Verlegespule an, die dadurch entsteht, daß der Spulendraht unter Ausbildung der Spulenkonfiguration auf der Verbindungsoberfläche 120 verlegt wird.

Der in **Fig. 11** dargestellte Schichtaufbau der IC-Karte 118 kann auch durch Ausbildung von Auftragsschichten aufeinander erfolgen, so daß etwa ausgehend von einer Trägerschicht, die als Einheit oder im Spritzverfahren auf die Rückhalteeinrichtung 41 aufgebracht wird, die weiteren Schichten in Spritztechnik aufgetragen werden.

## Patentansprüche

1. IC-Kartenmodul (20, 49, 75, 115) zur Herstellung einer IC-Karte (118) mit mindestens einer Spule (46, 72, 108, 113, 114) und mindestens einem Chip (23, 66, 97) zur Ausbildung einer Transpondereinheit, wobei der Chip (23, 66, 97) und die Spule (46, 72, 108, 113, 114) über einen Modulträger (21, 50, 76) miteinander verbunden sind, der sowohl Spulenkontakt-Leiterbahnen (26, 27; 57, 58; 104, 105) zur elektrisch leitfähigen Verbindung zwischen dem Chip (23, 66, 97) und der Spule (46, 72, 108, 113, 114) als auch Außenkontakt-Leiterbahnen (28 bis 31; 51 bis 56; 77 bis 88) zur elektrisch leitfähigen Verbindung zwischen einer Außenkontaktfläche (38, 65, 133) des Modulträgers (21, 50, 76) und dem Chip (23, 66, 97) aufweist, und wobei das IC-Kartenmodul (20, 49, 75, 115) eine Rückhalteeinrichtung (41, 73, 110) zur Sicherung des IC-Kartenmoduls (20, 49, 75, 115) in einem Kartenkörper (125) aufweist,
dadurch **gekennzeichnet,**
daß zur Ausbildung der Rückhalteeinrichtung (41, 73, 110) die Spule (46, 72, 108, 113, 114) derart gegenüber dem Modulträger (21, 50, 76) angeordnet ist, daß sie sich zumindest teilweise über die Fläche des Modulträgers (21, 50, 76) hinaus erstreckt.

2. IC-Kartenmodul (20, 49, 75, 115) zur Herstellung einer IC-Karte (118) mit mindestens einer Spule (46, 72, 108, 113, 114) und mindestens einem Chip (23, 66, 97) zur Ausbildung einer Transpondereinheit, wobei der Chip (23, 66, 97) und die Spule (46, 72, 108, 113, 114) über einen Modulträger (21, 50, 76) miteinander verbunden sind, der sowohl Spulenkontakt-Leiterbahnen (26, 27; 57, 58; 104, 105) zur elektrisch leitfähigen Verbindung zwischen dem Chip (23, 66, 97) und der Spule (46, 72, 108, 113, 114) als auch Außenkontakt-Leiterbahnen (28 bis 31; 51 bis 56; 77 bis 88) zur elektrisch leitfähigen Verbindung zwischen einer Außenkontaktfläche (38, 65, 133) des Modulträgers (21, 50, 76) und dem Chip (23, 66, 97) aufweist, und wobei das IC-Kartenmodul (20, 49, 75, 115) eine Rückhalteeinrichtung (41, 73, 110) zur Sicherung des IC-Kartenmoduls (20, 49, 75, 115) in einem Kartenkörper (125) aufweist,
dadurch **gekennzeichnet,**
daß die Spulenkontakt-Leiterbahnen (26, 27; 57, 58; 104, 105) gegenüberliegend den Außenkontakt-Leiterbahnen (28 bis 31; 51 bis 56; 77 bis 88) auf dem Modulträger (21, 50, 76) angeordnet sind, und die Rückhalteeinrichtung (41, 73, 110) durch die Spulenkontakt-Leiterbahnen (26, 27; 57, 58; 104, 105) gebildet ist.

3. IC-Kartenmodul nach Anspruch 1 oder 2,
dadurch **gekennzeichnet,**
daß die Kontaktierung von Spulendrahtenden (44, 45) der Spule (46) auf Leiterbahnenden der Spulenkontakt-Leiterbahnen (26, 27) auf der einer Außenkontaktflächenebene (42) zugewandten Kontaktfläche (43) vorgesehen ist.

4. IC-Kartenmodul nach einem oder mehreren der vorangehenden Ansprüche,
dadurch **gekennzeichnet,**
daß zur Verbindung von Chipanschlußflächen (24, 67) mit den Spulenkontakt-Leiterbahnen (26, 27; 57, 58) und den Außenkontakt-Leiterbahnen (28 bis 31; 51 bis 56) Drahtbondverbindungen (25; 68) vorgesehen sind.

5. IC-Kartenmodul nach einem oder mehreren der Ansprüche 1 bis 3,
dadurch **gekennzeichnet,**
daß die Spulenkontakt-Leiterbahnen (104, 105) und die Chip-Anschlußflächen (96) sowie die Außenkontakt-Leiterbahnen (77 bis 88) und die Chip-Anschlußflächen (96) über 'Kontaktmetallisierungen (132) miteinander verbunden sind.

6. IC-Kartenmodul nach einem oder mehreren der vorangehenden Ansprüche,
dadurch **gekennzeichnet,**
daß die Außenkontakt-Leiterbahnen (28 bis 31; 51 bis 56; 77 bis 88) in die Kontaktfelder (32 bis 37; 59 bis 64; 98 bis 103) übergehend ausgebildet sind.

7. IC-Kartenmodul nach Anspruch 6,
dadurch **gekennzeichnet,**
daß die Kontaktfelder (32 bis 37; 59 bis 64; 98 bis 103) durch Endbereiche der Außenkontakt-Leiterbahnen (28 bis 31; 51 bis 56; 77 bis 88) gebildet sind.

8. IC-Karte mit einem IC-Kartenmodul nach einem oder mehreren der vorangehenden Ansprüche,
dadurch **gekennzeichnet,**
daß das IC-Kartenmodul (20) derart in einem Kartenkörper (125) der IC-Karte (118) angeordnet ist, daß die mit mindestens einem Kontaktfeld (32 bis 37) versehene Außenkontaktfläche (38) im wesentlichen bündig mit der Oberfläche des Kartenkörpers (125) angeordnet ist und die Rückhalteeinrichtung (41) des IC-Kartenmoduls (20) einen an die Außenkontaktfläche (38) angrenzenden Rückhaltebereich (129, 130) des Kartenkörpers (125) hintergreift.

9. IC-Karte nach Anspruch 8,
dadurch **gekennzeichnet,**
daß der Rückhaltebereich Teil eines monolithisch ausgebildeten Kartenkörpers ist.

10. IC-Karte nach Anspruch 8,
dadurch **gekennzeichnet,**
daß der Rückhaltebereich Teil einer Trägerschicht (119) eines zumindest aus zwei Schichten gebildeten Kartenkörpers (125) ist.

11. IC-Karte nach Anspruch 10,
dadurch **gekennzeichnet,**
daß die Rückhalteeinrichtung (41) zwischen der Trägerschicht (119) und einer Gegenschicht (124) aufgenommen wird, wobei die Rückhalteeinrichtung zumindest teilweise in der Trägerschicht eingebettet ist.

12. IC-Karte nach Anspruch 10,
dadurch **gekennzeichnet,**
daß die Rückhalteeinrichtung (41) zwischen der Trägerschicht (119) und einer Gegenschicht (124) aufgenommen wird, wobei die Rückhalteeinrichtung mittels eines Kleberauftrags mit der Trägerschicht (119) verbunden ist.

13. Verfahren zur Herstellung einer IC-Karte nach Anspruch 10 oder 11,
dadurch **gekennzeichnet**,
daß das IC-Kartenmodul (20) mit der Außenkontaktfläche (38) bis zur Anlage der Rückhalteeinrichtung (41) an einer Verbindungsoberfläche (120) der Trägerschicht (119) in eine Einsetzöffnung (122) der Trägerschicht (119) eingebracht wird, eine Verbindung der Rückhalteeinrichtung (41) unter Einwirkung von Druck und Temperatur und/oder Ultraschall erfolgt und anschließend die Gegenschicht (124) auf die Verbindungsoberfläche (120) der Trägerschicht (119) aufgebracht wird.

14. Verfahren zur Herstellung einer IC-Karte nach Anspruch 10 oder 11,
dadurch **gekennzeichnet,**
daß auf die Rückhalteeinrichtung (41) eine Trägerschicht mit einer Einsetzöffnung im Bereich der Außenkontaktfläche (38) des IC-Kartenmoduls (20) ausgebildet wird, derart, daß eine Verbindung zwischen der Rückhalteeinrichtung (41) und der Trägerschicht (119) erfolgt, und anschließend die Gegenschicht (124) auf die Trägerschicht (119) und eine der Außenkontaktfläche (38) gegenüberliegende Rückseite des IC-Kartenmoduls (20) aufgebracht wird.

15. Verfahren zur Herstellung einer IC-Karte nach Anspruch 9,
dadurch **gekennzeichnet,**
daß auf der Rückhalteeinrichtung (41) der Kartenkörper (125) mit einer Ausnehmung im Bereich der Außenkontaktfläche (38) des IC-Kartenmoduls (20) ausgebildet wird.

## Claims

1. IC card module (20, 49, 75, 115) for producing an IC card (118) having at least one coil (46, 72, 108, 113, 114) and at least one chip (23, 66, 97) for the formation of a transponder unit, with the chip (23, 66, 97) and the coil (46, 72, 108, 113, 114) being connected together by way of a module carrier (21, 50, 76) which not only has coil contact printed conductors (26, 27; 57, 58; 104, 105) for the purpose of establishing an electrically conductive connection between the chip (23, 66, 97) and the coil (46, 72, 108, 113, 114), but also has external contact printed conductors (28 to 31; 51 to 56; 77 to 88) for the purpose of establishing an electrically conductive connection between an external contact face (38, 65, 133) of the module carrier (21, 50, 76) and the chip (23, 66, 97), and with the IC card module (20, 49, 75, 115) having a retaining device (41, 73, 110) for the purpose of securing the IC card module (20, 49, 75, 115) in a card body (125), characterised in that for the purpose of forming the retaining device (41, 73, 110) the coil (46, 72, 108, 113, 114) is arranged in relation to the module carrier (21, 50, 76) in such a way that it extends at least in part beyond the surface of the module carrier (21, 50, 76).

2. IC card module (20, 49, 75, 115) for producing an IC card (118) having at least one coil (46, 72, 108, 113, 114) and at least one chip (23, 66, 97) for the formation of a transponder unit, with the chip (23, 66, 97) and the coil (46, 72, 108, 113, 114) being connected together by way of a module carrier (21, 50, 76) which not only has coil contact printed conductors (26, 27; 57, 58; 104, 105) for the purpose of establishing an electrically conductive connection between the chip (23, 66, 97) and the coil (46, 72, 108, 113, 114), but also has external contact printed conductors (28 to 31; 51 to 56; 77 to 88) for the purpose of establishing an electrically conductive connection between an external contact face (38, 65, 133) of the module carrier (21, 50, 76) and the chip (23, 66, 97), and with the IC card module (20, 49, 75, 115) having a retaining device (41, 73, 110) for the purpose of securing the IC card module (20, 49, 75, 115) in a card body (125), characterised in that the coil contact printed conductors (26, 27; 57, 58; 104, 105) are arranged on the module carrier (21, 50, 76) in such a way that they lie opposite the external contact printed conductors (28 to 31; 51 to 56; 77 to 88), and the retaining device (41, 73, 110) is formed by the coil contact printed conductors (26, 27; 57, 58; 104, 105).

3. IC card module according to claim 1 or 2, characterised in that it is provided that coil wire ends (44, 45) of the coil (46) be contacted with printed-conductor ends of the coil contact printed conductors (26, 27) on the contact face (43) that faces an external contact face plane (42).

4. IC card module according to one or more of the preceding claims, characterised in that wire-bonding connections (25; 68) are provided for the purpose of connecting chip terminal faces (24, 67) to the coil contact printed conductors (26, 27; 57, 58) and the external contact printed conductors (28 to 31; 51 to 56).

5. IC card module according to one or more of the claims 1 to 3, characterised in that the coil contact printed conductors (104, 105) and the chip terminal faces (96) and also the external contact printed conductors (77 to 88) and the chip terminal faces (96) are connected together by way of contact metal coatings (132).

6. IC card module according to one or more of the preceding claims, characterised in that the external contact printed conductors (28 to 31; 51 to 56; 77 to 88) are formed so that they verge into the contact fields (32 to 37; 59 to 64; 98 to 103).

7. IC card module according to claim 6, characterised in that the contact fields (32 to 37; 59 to 64; 98 to 103) are formed by means of end regions of the external contact printed conductors (28 to 31; 51 to 56; 77 to 88).

8. IC card having an IC card module according to one or more of the preceding claims, characterised in that the IC card module (20) is arranged in a card body (125) of the IC card (118) in such a way that the external contact face (38), which is provided with at least one contact field (32 to 37), is arranged so as to be substantially flush with the surface of the card body (125), and the retaining device (41) of the IC card module (20) engages behind a retaining area (129, 130) of the card body (125) that is adjacent to the external contact face (38).

9. IC card according to claim 8, characterised in that the retaining area is part of a monolithically formed card body.

10. IC card according to claim 8, characterised in that the retaining area is part of a carrier layer (119) of a card body (125) which is formed from at least two layers.

11. IC card according to claim 10, characterised in that the retaining device (41) is received between the carrier layer (119) and a counter-layer (124), with the retaining device being embedded at least in part in the carrier layer.

12. IC card according to claim 10, characterised in that the retaining device (41) is received between the carrier layer (119) and a counter-layer (124), with the retaining device being connected to the carrier layer (119) by means of an adhesive coating.

13. Method for producing an IC card according to claim 10 or 11, characterised in that the IC card module (20) is introduced, with the external contact face (38), into an insertion opening (122) of the carrier layer (119) until the retaining device (41) abuts against a connecting surface (120) of the carrier layer (119), the retaining device (41) is connected under the influence of pressure and temperature and/or ultrasound, and subsequently the counter-layer (124) is applied to the connecting surface (120) of the carrier layer (119).

14. Method for producing an IC card according to claim 10 or 11, characterised in that a carrier layer having an insertion opening in the region of the external contact face (38) of the IC card module (20) is formed on the retaining device (41) in such a way that a connection is effected between the retaining device (41) and the carrier layer (119), and subsequently the counter-layer (124) is applied to the carrier layer (119) and a rear side of the IC card module (20) that lies opposite the external contact face (38).

15. Method for producing an IC card according to claim 9, characterised in that the card body (125) having a recess in the region of the external contact face (38) of the IC card module (20) is formed on the retaining device (41).

## Revendications

1. Module de carte à circuits intégrés (20,49,75, 115) pour fabriquer une carte à circuits intégrés (118) comportant au moins une bobine (46,72,108,113,114) et au moins une plaquette (23,66,97) pour former une unité formant transpondeur, dans lequel la plaquette (23,66,97) et la bobine (46,72,108,113,114) sont reliées entre elles par l'intermédiaire d'un porte-module (21,50,76) qui porte aussi bien des voies conductrices (26,27;57,58;104,105) de contact avec la bobine pour établir une liaison électriquement conductrice entre la plaquette (23,66,97) et la bobine (46,72,108,113,114), que des voies conductrices (28 à 31; 51 à 56; 77 à 88) de contact extérieur pour établir une liaison électriquement conductrice entre une surface de contact extérieure (38,65,133) du porte-module (21,50,76) et la plaquette (23,66,97), et dans lequel le module de carte à circuits intégrés (20,49,75,115) comporte un dispositif de retenue (41,73,110) pour bloquer le module de carte à circuits intégrés (20,49,75,115) dans un corps (125) de la carte,
caractérisé en ce
que pour la formation du dispositif de retenue (41,73,110), la bobine (46,72,108,113,114) est disposée en vis-à-vis du porte-module (21,50,56) de telle sorte que la bobine s'étend au moins en partie sur la surface du porte-module (21,50,76).

2. Module de carte à circuits intégrés (20,49,75, 115) pour la fabrication d'une carte à circuits intégrés (118) comportant au moins une bobine (46,72,108,113,114) et au moins une plaquette (23,66,97) pour former une unité formant transpondeur, dans lequel la plaquette (23,66,97) et la bobine (46,72,108,113,114) sont reliées entre elles par l'intermédiaire d'un porte-module (21,50,76) qui porte aussi bien des voies conductrices (26,27;57,58;104,105) de contact avec la bobine pour établir une liaison électriquement conductrice entre la plaquette (23,66,97) et la bobine (46,72,108,113,114), que des voies conductrices (28 à 31; 51 à 56; 77 à 88) d'établissement de contact extérieur pour établir une liaison électriquement conductrice entre une surface de contact extérieure (38,65,133) du porte-module (21,50,76) et la plaquette (23,66,97), et dans lequel le module de carte à circuits intégrés (20,49,75, 115) comporte un dispositif de retenue (41,73,110) pour bloquer le module de carte à circuits intégrés (20,49,75, 115) dans un corps (125) de la carte,
caractérisé en ce
que les voies conductrices (26,27; 57,58; 104,105) de contact avec la bobine sont disposées en vis-à-vis des voies conductrices (28 à 31; 51 à 56; 77 à 88) des contacts extérieurs sur le porte-module (21,50,76) et le dispositif de retenue (41,73,110) est formé par les voies conductrices (26,27; 57,58; 104,105) de contact avec la bobine.

3. Module de carte à circuits intégrés selon la revendication 1 ou 2, caractérisé en ce que l'établissement du contact d'extrémités (44,45) de fils de la bobine (46) sur des extrémités des voies conductrices (26,27) de contact avec la bobine est prévu sur la surface de contact (43) tournée vers un plan (42) de la surface de contact extérieure.

4. Module de carte à circuits intégrés selon une ou plusieurs des revendications précédentes,
caractérisé en ce
qu'il est prévu des liaisons (25;68) de connexion de fils pour relier des surfaces (24,67) de connexion de plaquette aux voies conductrices (26,27;57,58) de contact avec la bobine et aux voies conductrices (28 à 31; 51 à 56) de contact extérieur.

5. Module de carte à circuits intégrés selon une ou plusieurs des revendications 1 à 3,
caractérisé en ce
que les voies conductrices (104,105) de contact avec la bobine et les surfaces (96) de connexion de plaquette ainsi que les voies conductrices (77 à 88) de contact extérieur et les surfaces (96) de connexion de plaquette sont reliées entre elles par l'intermédiaire de métallisations de contact (132).

6. Module de carte à circuits intégrés selon une ou plusieurs des revendications précédentes,
caractérisé en ce
que les voies conductrices (28 à 31; 51 à 56; 77 à 88) de contact extérieur sont réalisées de manière à se prolonger par les plages de contact (32 à 37; 59 à 64; 98 à 103).

7. Module de carte à circuits intégrés selon la revendication 6,
caractérisé en ce
que les plages de contact (32 à 37; 59 à 64; 98 à 103) sont formées par des parties d'extrémité des voies conductrices (28 à 31; 51 à 56; 77 à 88) de contact extérieur.

8. Carte à circuits intégrés comportant un module de carte à circuits intégrés selon une ou plusieurs des revendications précédentes,
caractérisée en ce
que le module de carte à circuits intégrés (20) est disposé dans un corps (125) de la carte à circuits intégrés (118), de telle sorte que la surface de contact extérieure (38), qui comporte au moins une plage de contact (32 à 37), est disposée essentiellement de niveau avec la surface du corps (125) de la carte et que le dispositif de retenue (41) du module (20) de la carte à circuits intégrés s'engage derrière une partie de retenue (129,130) du corps de la carte (125), qui jouxte la surface de contact extérieure (38).

9. Carte à circuits intégrés selon la revendication 8,
caractérisée en ce
que la partie de retenue fait partie d'un corps de carte formé de façon monolithique.

10. Carte à circuits intégrés selon la revendication 8,
caractérisée en ce
que la partie de retenue fait partie d'une couche de support (119) d'un corps de carte (125) formé au moins de deux couches.

11. Carte à circuits intégrés selon la revendication 10,
caractérisée en ce
que le dispositif de retenue (41) est logé entre la couche de support (119) et une couche antagoniste (124), le dispositif de retenue étant enrobé au moins en partie dans la couche de support.

12. Carte à circuits intégrés selon la revendication 10,
caractérisée en ce
que le dispositif de retenue (41) est logé entre la couche de support (119) et une couche antagoniste (124), le dispositif de retenue étant relié au moyen d'un dépôt de colle à la couche de support (119).

13. Procédé pour fabriquer une carte à circuits intégrés selon la revendication 10 ou 11,
caractérisé en ce
que le module de carte à circuits intégrés (20) est inséré, avec la surface de contact extérieure (38), dans une ouverture d'insertion (122) de la couche de support (119) jusqu'à ce que le dispositif de retenue (41) s'applique contre une surface de liaison (120) de la couche de support (119), une liaison du dispositif de retenue (41) est établie moyennant l'action d'une pression et d'une température et/ou d'ultrasons et ensuite la couche antagoniste (124) est appliquée sur la surface de liaison (120) de la couche de support (119).

14. Procédé pour fabriquer une carte à circuits intégrés selon la revendication 10 ou 11,
caractérisé en ce
que sur le dispositif de retenue (41) est formée une couche de support comportant une ouverture d'insertion dans la zone de la surface de contact extérieure (38) du module de carte à circuits intégrés (20), de telle sorte qu'une liaison est établie entre le dispositif de retenue (41) et la couche de support (119), et qu'ensuite la couche antagoniste (124) est appliquée sur la couche de support (119) et sur une face arrière du module de carte à circuits intégrés (20), située en vis-à-vis de la surface de contact extérieure (38).

15. Procédé pour fabriquer une carte à circuits intégrés selon la revendication 9,
caractérisé en ce
que le corps (125) de la carte possédant un évidement dans la zone de la surface de contact extérieure (38) du module de carte à circuits intégrés (20) est formé sur le dispositif de retenue (41).
